# FASCICULE DE BREVET EUROPEEN

(11) **EP 0 508 843 B1**
(45) Date de publication et mention de la délivrance du brevet: **23.04.1997**
(21) Numéro de dépôt: 92400589.5
(22) Date de dépôt: 06.03.1992
(51) Int. Cl.: H01L 39/22

(54) **Dispositif semiconducteur à effet Josephson**
Josephsoneffekt-Halbleiteranordnung
Semiconductor device using Josephson effect

(30) Priorité: 15.03.1991 FR 9103186
(43) Date de publication de la demande: 14.10.1992
(73) Titulaire: THOMSON-CSF, 75008 Paris (FR)
(72) Inventeur: Schuhl, Alain, F-92045 Paris la Défense (FR); Tyc, Stéphane, F-92045 Paris la Défense (FR); Friederich, Alain, F-92045 Paris la Défense (FR)
(74) Mandataire: Guérin, Michel

(56) Documents cités:
- EP-A- 0 181 191
- EP-A- 0 305 167
- EP-A- 0 413 333
- PATENT ABSTRACTS OF JAPAN, vol. 12, no. 423 (E-680) 9 Novembre 1988 & JP-A-63 160 273

## Description

La présente invention concerne un transistor à effet de champ à effet Josephson, dans lequel la couche active, en matériau semiconducteur est déposée sur une couche de matériau supraconducteur.

L'effet Josephson est un effet lié aux supraconducteurs, selon lequel un courant supraconducteur, ou supracourant, peut exister dans un métal ou dans un semiconducteur par effet de proximité avec un supraconducteur.

Les composants basés sur un effet supraconducteur trouveront certainement de nombreuses applications dans un proche avenir. Leur faible dissipation thermique associée à une très grande vitesse de commutation font qu'ils sont particulièrement intéressants pour les circuits logiques à haute intégration, de types LSI ou VLSI.

Plusieurs modèles de transistors à effet de champ utilisant l'effet Josephson (JOFETs) ont été décrits, en particulier par A.W. Kleinsasser et al. dans "Superconducting Devices", édité par S. Ruggiera et D.Rudman, Academic Press, 1990 ou dans les demandes de brevets EP-A-0 305 167, EP-A-0 181 191. Il s'agit d'un transistor à effet de champ à architecture tout à fait classique, dont les métallisations de source et de drain sont en matériaux supraconducteurs. Le canal semiconducteur supporte un courant supraconducteur -modulé par la grille- en raison de l'effet de proximité précédemment cité.

Toutefois, l'une des limitations principales dans ces types de transistors provient de la faible longueur de cohérence de la supraconductivité dans les matériaux semiconducteurs, c'est à dire de la longueur sur laquelle s'exerce l'effet de proximité. Pour obtenir des supracourants significatifs, il faut des longueurs de canal extrêmement faibles : de l'ordre de 10 à 1000 A° soit 0,1 µm. De telles valeurs sont actuellement connues de l'homme de l'art et notamment enseignées dans la demande de brevet EP-A-0 413 333. Avec les technologies de masquage actuelles, même par faisceaux d'électrons ou rayons X, on ne sait pas réaliser un transistor dont la source et le drain sont éloignés de 0,1 µm, et avec en outre une métallisation de grille entre les deux metallisations de source et drain.

C'est pourquoi les caractéristiques des JOFETs selon l'art connu ne sont pas suffisamment bonnes pour être utiles.

Le brevet japonais JP-A-63 160 273 (Patent Abstract of Japan, vol 12, n° 423 (3-680), 9 novembre 1988) propose une structure originale présentant une alternance de couches supraconductrices semiconductrices permettant d'élaborer un canal parallèle au plan des couches directement sous les électrodes source et drain. Une telle structure nécessite cependant un grand nombre de dépôts de couches moléculaires rendant la fabrication de tels dispositifs assez lourde et délicate.

C'est pourquoi, l'invention propose un dispositif dont le canal est divisé en deux canaux verticaux compris dans une couche de matériau semiconducteur déposée sur une couche de matériau supraconducteur, et un supracourant se déplaçant dans les canaux semiconducteurs par effet de proximité. Il faut pour cela que l'épaisseur de la couche semiconductrice soit au plus égale à la longueur de cohérence, pour la paire des matériaux considérés : supra- et semi-conducteurs. On a donc remplacé une difficulté actuellement insoluble de masquage dans un plan horizontal par une difficulté parfaitement maîtrisée d'épaisseur d'épitaxie.

De façon plus précise, l'invention concerne un dispositif semiconducteur à effet Josephson, comportant un substrat, une couche de matériau semiconducteur et au moins deux électrodes d'accès dites sources et drain en matériau supraconducteur, sur ladite couche de matériau semiconducteur caractérisé en ce qu'il comporte une couche de matériau supraconducteur à la surface du substrat et sur laquelle couche est déposée la couche de matériau semiconducteur, ladite couche ayant une épaisseur au plus égale à la longueur de cohérence de la supraconductivité dans ledit matériau semiconducteur, pour avoir un canal de commande comprenant deux canaux perpendiculaires au plan des couches, situés respectivement entre la source et ladite couche de matériau supraconducteur, et entre le drain et ladite couche de matériau supraconducteur.

L'invention sera mieux comprise par la description plus détaillée qui suit d'un exemple de transistor à supraconducteur, en liaison avec les figures jointes en annexe, qui représentent : :
- figure 1 : vue en coupe d'un transistor à effet de champ à supraconducteur selon l'invention,
- figures 2 et 3 : vues en coupes de la région de canal d'un transistor selon l'invention, pour deux tensions différentes de grille,
- figure 4 : vue en coupe de la région de canal d'un transistor selon l'invention, dans une variante structurelle d'action de la grille,
- figure 5 : second exemple de variante structurelle avec une grille implantée,
- figure 6 : structure du dispositif en photodiode,
- figures 7 et 8 : vues en coupe pour la figure 7 et en plan pour la figure 8 d'un transistor à gain élevé, selon l'invention.

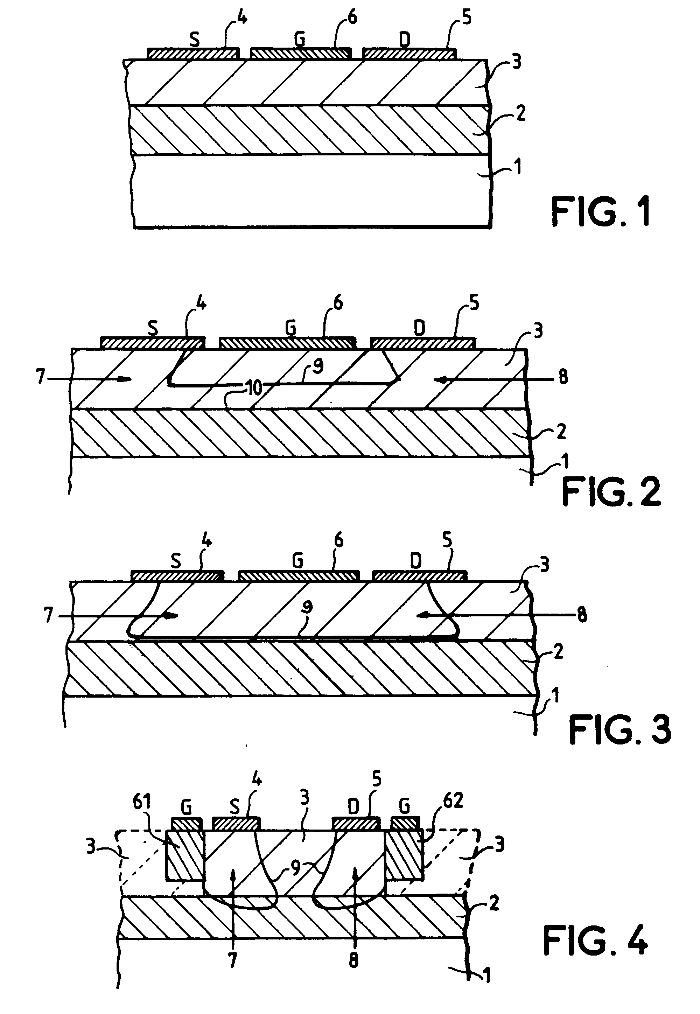

La figure 1 donne une coupe d'un JOFET selon l'invention, mais elle est tout à fait générale : le nombre, la nature et la forme (tranchée,mésa...) des couches peuvent être différentes, selon les besoins de l'application qui en est faite.

Le transistor comprend un substrat 1, qui peut être soit en silicium (semiconducteur), soit en matériaux du groupe III-V tel que GaAs (ils peuvent être semi-isolants), soit encore en matériaux qui ne sont pas des semiconducteurs, tels que le saphir, la zircone, le verre, l'alumine, le nitrure d'aluminium, le titanate de strontium etc.... En effet, sur ce substrat est déposée une couche 2 de matériaux supraconducteur, et on n'a donc plus les mêmes problèmes d'adaptation de paramètres de mailles cristallines qu'entre Si et GaAs par exemple. Une couche tampon peut être éventuellement nécessaire, selon le couple de matériaux en présence.

La couche 2 en supraconducteur a une épaisseur de l'ordre de 1000 A°, ou 0,1 µm : elle est déposée par pulvérisation cathodique (sputtering), par ablation laser, ou par épitaxie par jet moléculaire (MBE) par exemple. La nature du matériau supraconducteur n'est pas spécifique de l'invention, mais c'est préférablement un supraconducteur à haute température critique, du type de ceux qui sont connus sous l'abréviation YBaCuO, dans lesquels l'yttrium peut être remplacé par le thallium, le dysprosium ou l'europium, ou encore du type des alliages plomb-étain-tellure dopés à l'indium. L'important dans le choix du matériau supraconducteur est que les conditions de dépôt et de recuit pour obtenir une fraction de volume supraconductrice importante soient compatibles avec la nature du substrat 1.

La couche supraconductrice 2 peut être uniforme sur le substrat 1, ou, comme on le verra ultérieurement, limitée à des régions qui correspondent au canal du transistor.

Sur la couche 2 de supraconducteur est déposée une couche 3 de matériau semiconducteur. Elle est représentée homogène sur la figure 1, mais elle peut en fait être plus complexe et comporter par exemple une couche de lissage au contact de la couche 2, et des régions de contact plus dopées sous les électrodes de source 4 et drain 5.

Celles-ci, déposées en surface de la couche semiconductrice, sont réalisées en matériaux supraconducteurs, de même que toute leur interconnexion, pour qu'un supracourant puisse circuler dans tout le circuit, sans qu'aucun élément ne vienne présenter une résistance élevée, lorsque le canal du transistor est supraconducteur.

L'électrode de grille 6, entre les deux électrodes de source et drain, peut être à contact Schottky, ou isolée par une couche (non représentée) d'oxyde ou d'isolant, ou encore être formée par une jonction pn. Il est important de signaler que la grille est longue, par rapport à l'art connu.

L'épaisseur de la couche semiconductrice 3 varie de 10 A° à 1000 A°, voire 1 µm, c'est à dire qu'elle est comparable à la longueur de cohérence pour le couple considéré supra- et semi-conducteurs : en effet, celle-ci varie de 10 A° pour les anciens matériaux supraconducteurs à 1000 A° pour les matériaux supraconducteurs dits à haute température critique (>20° K). Elle atteint même 1 µm dans certains cas. L'effet Josephson peut alors se produire verticalement, perpendiculairement aux couches, deux fois, entre l'électrode de source 4 et la couche supraconductrice enterrée 2, d'une part, et entre l'électrode de drain 5 et la même couche 2, d'autre part. La structure verticale du dispositif simplifie notablement sa réalisation. En effet, les techniques usuelles de croissance de matériaux permettent des résolutions verticales bien plus fines que les résolutions horizontables obtenues par des techniques de gravure : on sait faire croître couche atomique par couche atomique.

Dans le plan horizontal, ou parallèlement aux couches, le canal semiconducteur du JOFET, qui va de la source au drain, a une longueur bien plus importante que la longueur de cohérence : dans l'état actuel de la technique, elle est de l'ordre de 1 à 3 µm. Mais ce canal semiconducteur dans la couche 3 est couplé à un canal supraconducteur dans la couche 2, qui assure une propagation de la cohérence, par effet de proximité , sur une distance plus importante que celle du seul effet Josephson.

Le fonctionnement de ce transistor est expliqué au moyen des figures 2 et 3 - sur lesquelles le substrat 1 n'est pas représenté, pour simplifier-.

Pour qu'un effet Josephson se produise entre deux couches de supraconducteurs, dans les régions 7 et 8 qui sont situées respectivement entre la source 4 et la couche 2, et entre le drain 5 et la couche 2, il faut non seulement que la couche semiconductrice 3 soit d'épaisseur inférieure à la longueur de cohérence, mais encore qu'il y ait suffisamment d'électrons en paires de Cooper pour assurer un supracourant vertical dans les régions 7 et 8, perpendiculairement aux couches.

Pour une première tension appliquée sur la grille 6, il se forme dans la région du canal entre source et drain, une zone enrichie ou déplétée 9, qui est totalement comprise dans la couche semiconductrice 3. Le fonctionnement est encore plus simple quand on travaille en enrichissement. La zone déplétée s'exerce en partie sous les métallisations de source et drain, puisqu'il a été précisé que la grille est longue, c'est à dire que les espaces grille-source et grille-drain sont petits. La composante latérale de ce champ crée suffisamment d'électrons pour que l'effet Josephson se produise en 7 et 8. On a donc un supracourant qui passe par le circuit source 4 + région 7+ couché 2+ région 8+ drain 5.

Puisqu'un supracourant circule dans la couche 2, la région 10, comprise entre la couche 2 et la zone déplétée sous la grille 6, est soumise à l'effet de proximité et un supracourant y circule également.

Pour une seconde tension appliquée sur la grille, en figure 3, la zone 9 déplétée par la grille se déplace. La région 10 disparaît.

Mais, surtout, la zone déplétée 9 se déplace également horizontalement, dans le plan de la couche semiconductrice 3, jusqu'à dépléter totalement d'électrons les régions 7 et 8 entre source/drain et couche supraconductrlce 2. Dans ces conditions, il ne peut plus y avoir d'effet Josephson, car, pour transporter un supracourant dans les régions 7 et 8, il faut qu'il y ait des électrons : or ils sont déplétés.

Pour cette seconde tension de grille, le transistor est bloqué, aucun supracourant ne circule dans le circuit source 4+ région 7+ couche 2+ région 8+ drain 5. On peut considérer que le canal de commande qui, selon l'art connu, réunit la source au drain, dans une direction parallèle au plan des couches, est, dans la structure selon l'invention, remplacé par deux canaux, qu'on appellera "pseudo-canaux" pour les différencier du canal de commande classique, qui sont perpendiculaires aux couches, et situés l'un entre la source et la couche 2, l'autre entre le drain et la même couche 2. En d'autres termes, le transistor selon l'invention possède deux pseudo-canaux de commande par effet Josephson, dans les régions 7 et 8.

Puisque les deux pseudo-canaux de commande 7 et 8 sont verticaux, et que pour la seconde tension de grille ils sont déplétés horizontalement, la structure de transistor a une seconde forme, symétrique de la première, représentée en figure 4. Une double grille de commande 61 et 62 est déposée à l'extérieur du volume défini par les pseudo-canaux 7 et 8, mais dans l'épaissseur de la couche semiconductrice 3. Sous l'action des deux champs électriques exercés par la grille, les électrons dans les régions 7 et 8 sont déplétés de l'extérieur vers l'intérieur, tandis que dans la solution précédente de la figure 3, ils étaient déplétés de l'intérieur vers l'extérieur, par gonflement de la zone déplétée 9.

La grille latérale, composée de deux parties 61 et 62 alimentées par une même source de tension, peut prendre différentes formes de réalisation. La figure 4 représente une structure mésa, limitée à la couche semiconductrice 3, dont les flancs sont métallisés en 61 et 62. Mais cette figure reste valable pour une structure planar : dans la couche semiconductrice 3, complétée en pointillés, deux sillons sont gravés puis métallisés. Il faut seulement limiter la profondeur des métallisations 61 et 62 pour qu'elles n'entrent pas en court-circuit avec la couche supraconductrice 2 lorsque les pseudo-canaux 7 et 8 sont conducteurs.

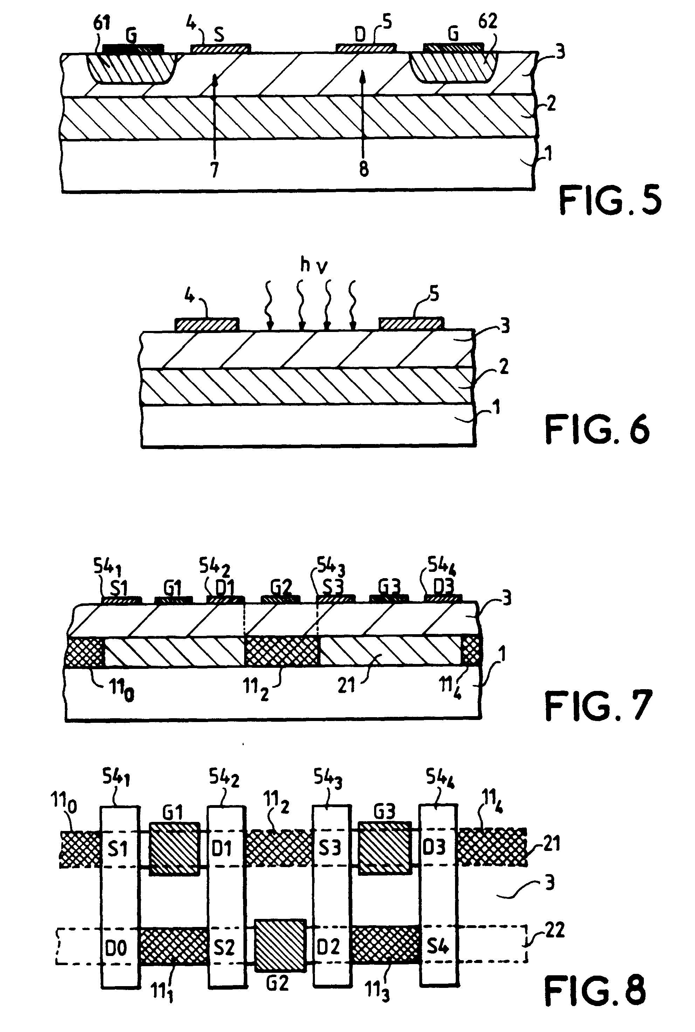

Il peut être préférable de réaliser deux diffusions ou deux implantations pour réaliser les deux parties 61 et 62 de la grille, comme représenté en figure 5.

Enfin, étant donné que la longueur de cohérence varie entre 10 et 1000 A°, exceptionellement 1 µm, selon la nature des matériaux semi- et supra-conducteurs, la couche semiconductrice 3 est transparente, par sa finesse, au rayonnement lumineux. Le transistor selon l'invention peut donc être, comme représenté en figure 6, un phototransistor commandé par un rayonnement électromagnétique hν. Il faut cependant prévoir de masquer une partie de la surface du phototransistor pour que celui-ci déplète soit selon le mécanisme de la figure 3 (grille centrale), soit selon le mécanisme de la figure 4 (grille externe).

Par rapport aux transistors classiques, les JOFETs souffrent d'une limitation intrinsèque : les tensions entre source et drain pour lesquelles les effets supraconducteurs sont importants sont limitées par l'énergie de condensation des paires de Cooper, soit environ 1 mV pour les supraconducteurs dits à basse température et jusque 10 mV pour les supraconducteurs dits à haute température. Ce qui ne permet pas d'obtenir des tensions de sortie importantes et donc de forts gains.

La structure représentée en coupe en figure 7 et en plan en figure 8 permet d'y remédier. Dans cette structure, une pluralité de JOFETs sont montés en série. La couche supraconductrice 2 n'est plus une couche homogène, mais elle comporte au moins deux bandes parallèles 21 et 22 de matériau supraconducteur, noyé dans une matrice de matériau semiconducteur 1 + 3. Il peut y avoir également un multiple de paires de bandes parallèles 21 et 22. Perpendiculairement à ces bandes 21 et 22 sont déposées, sur la couche semiconductrice 3, des bandes parallèles 54₁, 54₂.... de matériau supraconducteur. La bande 54ᵢ met en série le drain 5 du transistor d'ordre i-1 avec la source 4 du transistor d'ordre i. Ainsi, à titre d'exemple non limitatif, la figure 8 représente trois transistors (S1, G1, D1) (S2, G2,D2) (S3, G3, D3) montés en série, dont les électrodes d'accès sont D0 et S4. Toutes les grilles G1,G2... sont montées en parallèle, et commandées par une même tension.

Ceci n'est possible qu'en détruisant la supraconductivité dans certains régions 11 des bandes 21 et 22, pour éviter que ces dites régions ne court-circuitent un transistor. Annuler la supraconductivité peut se faire par exemple par implantation d'ions. Ainsi, sur la figure 7 qui est une coupe au niveau de la bande 21, la région implantée 11₂, placée entre les transistors 1 (S1,G1,D1) et 3 (S3,G3,D3), évite que la bande supraconductrice 21 ne court-circuite le transistor 2 (S2, G2, D2) formé sur la bande 22. La série de transistors forme une grecque, qui contourne les ilôts non supraconducteurs 11ᵢ.

Enfin, étant donné ce qui a été dit sur le rôle de la couche semiconductrice 3, qui n'intervient que dans les régions 7 et 8, elle peut avoir des propriétés électriques inhomogènes : la couche 3 peut être par exemple en GaAs semi-isolant dopé seulement sous les métallisations de sources et drains, dans les régions des pseudo-canaux 7 et 8.

Les exemples exposés n'ont d'autre but que d'expliquer l'invention de façon claire, mais il est évident que des variantes évidentes pour l'homme de l'art, telles que la nature des matériaux, la forme ou la fonction des électrodes, entrent également dans le domaine de l'invention.

## Revendications

1. Dispositif semiconducteur à effet Josephson, comportant un substrat (1), une couche de matériau semiconducteur (3) et au moins deux électrodes d'accès (4, 5) dites sources et drain en matériau supraconducteur, sur ladite couche de matériau semiconducteur caractérisé en ce qu'il comporte une couche de matériau supraconducteur (2) à la surface du substrat (1) et sur laquelle couche (2) est déposée la couche de matériau semiconducteur (3), ladite couche (3) ayant une épaisseur au plus égale à la longueur de cohérence de la supraconductivité dans ledit matériau semiconducteur, pour avoir un canal de commande comprenant deux canaux (7, 8) perpendiculaires au plan des couches, situés respectivement entre la source (4) et ladite couche de matériau supraconducteur, et entre le drain (8) et ladite couche de matériau supraconducteur.

2. Dispositif semiconducteur à effet Josephson selon la revendication 1, caractérisé en ce qu'il comprend une électrode de commande (6) dite grille située entre les électrodes d'accès (4, 5) sur la couche de matériau semiconducteur (3).

3. Dispositif à effet Josephson selon la revendication 2, caractérisé en ce que la grille (6) est en métal non supraconducteur, située entre les électrodes d'accès (4,5) sur la couche semiconductrice (3).

4. Dispositif à effet Josephson selon la revendication 2, caractérisé en ce que la grille (6) est constituée de deux électrodes (61,62) , les électrodes d'accès (4,5) étant situées entre ces deux électrodes (61, 62).

5. Dispositif à effet Josephson selon la revendication 2, caractérisé en ce que la grille (61,62) est formée par deux régions diffusées ou implantées dans la couche semiconductrice, situées à l'extérieur de la région définie par les électrodes d'accès (4,5).

6. Dispositif à effet Josephson selon la revendication 2, caractérisé en ce que la couche semiconductrice (3) est dopée de façon homogène, dans tout son volume.

7. Dispositif à effet Josephson selon la revendication 2, caractérisé en ce que la couche semiconductrice (3) est inhomogène, dopée seulement entre les électrodes d'accès (4,5) et la couche supraconductrice (2).

8. Dispositif à effet Josephson selon la revendication 2, caractérisé en ce que la couche supraconductrice (2) est constituée par une bande (21) de matériau supraconducteur noyé dans le matériau semiconducteur (1,3).

9. Dispositif à effet Josephson selon la revendication 8, caractérisé en ce que, en vue d'augmenter la tension appliquée entre les électrodes d'accès (4,5), la dite tension étant limitée par l'énergie de condensation des électrons qui assurent la supraconductivité, au moins deux dispositifs à effet Josephson sont montés en série sur une bande (21) de matériau supraconducteur, et sont séparés par au moins une région (11) rendue non supraconductrice, de ladite bande (21).

## Patentansprüche

1. Halbleitervorrichtung mit Josephson-Effekt und mit einem Substrat (1), einer Schicht (3) aus Halbleitermaterial und mindestens zwei Zugangselektroden (4, 5), die Source- und Drainelektrode genannt werden und aus supraleitendem Material auf die Schicht aus Halbleitermaterial aufgebracht sind, dadurch gekennzeichnet, daß sie eine Schicht aus supraleitendem Material (2) an der Oberfläche des Substrats (1) besitzt und daß auf diese Schicht (2) die Schicht aus Halbleitermaterial (3) aufgebracht ist, deren Dicke höchstens gleich der Kohärenzlänge der Supraleitfähigkeit in dem halbleitenden Material ist, so daß sich ein Steuerkanal bestehend aus zwei zur Schichtebene senkrechten Kanälen (7, 8) ergibt, die zwischen der Sourceelektrode (4) und der Schicht aus supraleitendem Material bzw. zwischen der Drainelektrode (8) und der Schicht aus supraleitendem Material liegen.

2. Halbleitervorrichtung mit Josephson-Effekt nach Anspruch 1, dadurch gekennzeichnet, daß sie eine Steuerelektrode (6), auch Gate genannt, besitzt, die zwischen den Zugangselektroden (4, 5) zur Schicht (3) aus Halbleitermaterial liegt.

3. Vorrichtung mit Josephson-Effekt nach Anspruch 2, dadurch gekennzeichnet, daß das Gate (6) aus einem nicht-supraleitenden Metall besteht und zwischen den Zugangselektroden (4, 5) zur halbleitenden Schicht (3) angeordnet ist.

4. Vorrichtung mit Josephson-Effekt nach Anspruch 2, dadurch gekennzeichnet, daß das Gate (6) aus zwei Elektroden (61, 62) besteht, zwischen denen die Zugangselektroden (4, 5) liegen.

5. Vorrichtung mit Josephson-Effekt nach Anspruch 2, dadurch gekennzeichnet, daß das Gate (61, 62) aus zwei durch Diffusion oder Implantierung in der halbleitenden Schicht gebildeten Zonen besteht, die außerhalb der durch die Zugangselektroden (4, 5) definierten Zone liegen.

6. Vorrichtung mit Josephson-Effekt nach Anspruch 2, dadurch gekennzeichnet, daß die halbleitende Schicht (3) homogen in ihrem ganzen Volumen dotiert ist.

7. Vorrichtung mit Josephson-Effekt nach Anspruch 2, dadurch gekennzeichnet, daß die halbleitende Schicht (3) inhomogen nur zwischen den Zugangselektroden (4, 5) und der supraleitenden Schicht (2) dotiert ist.

8. Vorrichtung mit Josephson-Effekt nach Anspruch 2, dadurch gekennzeichnet, daß die supraleitende Schicht (2) von einem Band (21) aus supraleitenden Material gebildet wird, das in das halbleitende Material (1, 3) eingebettet ist.

9. Vorrichtung mit Josephson-Effekt nach Anspruch 8, dadurch gekennzeichnet, daß zur Erhöhung der zwischen die Zugangselektroden (4, 5) angelegten Spannung, die durch die Kondensationsenergie der Elektronen begrenzt wird, welche die Supraleitfähigkeit gewährleisten, mindestens zwei Josephson-Effekt-Vorrichtungen in Reihe auf einem Band (21) aus supraleitendem Material aufgebaut sind und durch mindestens eine Zone (11) des Bandes (21) getrennt sind, die nicht-supraleitend gemacht wurde.

## Claims

1. Josephson-effect semiconductor device which includes a substrate (1), a layer of semiconductor material (3) and at least two access electrodes (4, 5), called sources and drain made of superconducting material, on the said layer of semiconductor material, characterized in that it includes a layer of superconducting material (2) at the surface of the substrate (1) and on which layer (2) the layer of semiconductor material (3) is deposited, the said layer (3) having a thickness at most equal to the coherence length of the superconductivity in the said semiconductor material, in order to have a control channel comprising two channels (7, 8) which are perpendicular to the plane of the layers and located, respectively, between the source (4) and the said layer of superconducting material and between the drain (8) and the said layer of superconducting material.

2. Josephson-effect semiconductor device according to Claim 1, characterized in that it comprises a control electrode (6), called gate, located between the access electrodes (4, 5), on the layer of semiconductor material (3).

3. Josephson-effect device according to Claim 2, characterized in that the gate (6) is made of non-superconducting metal, located between the access electrodes (4, 5) on the semiconductor layer (3).

4. Josephson-effect device according to Claim 2, characterized in that the gate (6) consists of two electrodes (61, 62), the access electrodes (4, 5) being located between these two electrodes (61, 62).

5. Josephson-effect device according to Claim 2, characterized in that the gate (61, 62) is formed by two regions diffused or implanted into the semiconductor layer, these regions being located outside the region defined by the access electrodes (4, 5).

6. Josephson-effect device according to Claim 2, characterized in that the semiconductor layer (3) is doped in a homogeneous manner throughout its volume.

7. Josephson-effect device according to Claim 2, characterized in that the semiconductor layer (3) is inhomogeneous, doped only between the access electrodes (4, 5) and the superconducting layer (2).

8. Josephson-effect device according to Claim 2, characterized in that the superconducting layer (2) consists of a strip (21) of superconducting material embedded in the semiconductor material (1, 3).

9. Josephson-effect device according to Claim 8, characterized in that, for the purpose of increasing the voltage applied between the access electrodes (4, 5), the said voltage being limited by the condensation energy of the electrons providing the superconductivity, at least two Josephson-effect devices are mounted in series on a strip (21) of superconducting material and are separated by at least one region (11) rendered non-superconducting, of the said strip (21).
